# EUROPÄISCHE PATENTSCHRIFT

(11) **EP 1 565 268 B1**
(45) Veröffentlichungstag und Bekanntmachung des Hinweises auf die Patenterteilung: **17.05.2006**
(21) Anmeldenummer: 03785685.3
(22) Anmeldetag: 28.11.2003
(51) Int. Cl.: B05B 1/20

(54) **DÜSENANORDNUNG**
NOZZLE ARRANGEMENT
ENSEMBLE BUSE

(30) Priorität: 29.11.2002 DE 10255884
(43) Veröffentlichungstag der Anmeldung: 24.08.2005
(73) Patentinhaber: ATOTECH Deutschland GmbH, 10553 Berlin (DE)
(72) Erfinder: KOPP, Lorenz, 90518 Altdorf (DE); KUNZE, Henry, 90530 Wendelstein (DE); WIENER, Ferdinand, 90559 Burgthann (DE)
(74) Vertreter: Banzer, Hans-Jörg
(86) Internationale Anmeldenummer: PCT/EP2003/013421
(87) Internationale Veröffentlichungsnummer: WO 2004/050256

(56) Entgegenhaltungen:
- US-A- 1 971 376
- US-A- 5 540 247
- US-A- 5 850 841
- US-B1- 6 250 318

## Beschreibung

Die vorliegende Erfindung betrifft eine Düsenanordnung, wie sie zur Behandlung eines Werkstücks mit einer Behandlungsflüssigkeit oder zum Fluten eines entsprechenden Behandlungsbads mit einer Behandlungsflüssigkeit eingesetzt werden kann. Insbesondere betrifft die vorliegende Erfindung eine Schwalldüsenanordnung, welche beispielsweise in Durchlaufanlagen zum nasschemischen Behandeln von Leiterplatten eingesetzt werden kann.

Düsenanordnungen der genannten Art sind weitläufig bekannt. So werden beispielsweise derartige Düsenanordnungen in Durchlaufanlagen zur naßchemischen Behandlung von Leiterplatten eingesetzt, um eine möglichst schnelle und gleichmäßige Behandlung der durchlaufenden Leiterplatten zu erzielen. Dabei werden bekannterweise mehrere derartige Düsenanordnungen oberhalb und/oder unterhalb der Durchlaufebene der Leiterplatten sowie quer zur Durchlaufrichtung der Leiterplatten angeordnet, aus denen die entsprechende Behandlungsflüssigkeit auf die Leiterplattenoberfläche gestrahlt oder von dieser abgesaugt wird, um somit einen ständigen und gleichmäßigen Austausch der Behandlungsflüssigkeit entlang der Oberfläche der Leiterplatten zu erzielen.

In der EP 1 187 515 A2 werden diesbezüglich eine Vielzahl unterschiedlicher Düsenanordnungen vorgeschlagen. Dabei kommen jeweils im Wesentlichen runde Rohre zum Einsatz, die unterschiedliche Düsenformen aufweisen. So können diese Düsenanordnungen beispielsweise schräg angeordnete Schlitzdüsen, in einer Vielzahl von Reihen nebeneinander angeordnete Runddüsen oder auch in einer Vielzahl von Reihen nebeneinander angeordnete und axial verlaufende Schlitzdüsen aufweisen.

Auch in der DE 37 08 529 A1 wird der Einsatz von Schlitzdüsen vorgeschlagen, wobei durch eine variable Schlitzbreite der entsprechenden Düse die Durchflussmenge und der Sprühdruck des jeweiligen Mediums eingestellt werden kann.

In der DE 35 28 575 A1 wird zum Reinigen, Aktivieren und/oder Metallisieren von Bohrlöchern in horizontal durchlaufenden Leiterplatten eine unterhalb der Durchlaufebene und senkrecht zur Durchlaufrichtung angeordnete Düse verwendet, aus welcher ein flüssiges Behandlungsmittel in Form einer stehenden Welle an die Unterseite der jeweils durchlaufenden Leiterplatte gefördert wird. Die Düse ist im oberen Teil eines Düsengehäuses angeordnet, welches aus einer Vorkammer mit Einlaufstutzen gebildet ist, wobei die Vorkammer wiederum mittels einer Lochmaske von einem oberen Teil des Düseninnenraums abgetrennt ist. Mit Hilfe der Lochmaske wird eine Verteilung der Strömung des flüssigen Behandlungsmittels zur Düse erzielt. Der Düseninnenraum vor der eigentlichen (Schlitz-)Düse dient als Vorkammer für eine gleichmäßige Ausbildung des Schwalls des flüssigen Behandlungsmittels.

In der EP 0 280 078 B1 ist eine Düsenanordnung zur Reinigung oder chemischen Behandlung von Werkstücken, insbesondere Leiterplatten, mittels einer entsprechenden Behandlungsflüssigkeit bekannt. Die Düsenanordnung umfasst einen unteren Zulaufkasten und einen Gehäusekasten, wobei durch den unteren Zulaufkasten die Behandlungsflüssigkeit durch im Boden des Gehäusekastens befindliche Bohrungen in das Innere des Gehäusekastens geführt wird. Der Gehäusekasten wiederum weist eine mittlere Trennwand in Kombination mit zwei Perforationsebenen und darüber angeordneten Schlitzen auf, wodurch erreicht wird, dass die Behandlungsflüssigkeit zu den beiden Schlitzen fließt und sich darüber zwei gleichmäßige, sinusförmige Schwallwellenprofile ausbilden, die die Werkstücke, insbesondere die Bohrlöcher von Leiterplatten, durchströmen und durch den Venturi-Effekt für einen intensiven Stoffaustausch sorgen. Eine Düsenanordnung mit den Merkmalen des Oberbegriffs des Anspruchs 1 ist aus US 5 850 841 bekannt.

Bei den bekannten Schwalldüsenanordnungen ist die Strömungsgeschwindigkeit am Einlass am höchsten, da hier die größte Flüssigkeitsmenge durchtritt. Mit zunehmender Entfernung vom Einlass nimmt die Strömungsgeschwindigkeit entsprechend ab, da über die einzelnen Düsenöffnungen jeweils nur ein Teil der Behandlungsflüssigkeit abfließt. Dadurch kommt es neben dem vorhandenen statischen Druck zu einem Staudruck und ungleichmäßigen Strömungsgeschwindigkeiten an den Düsenöffnungen. Eine weitere Folge sind unterschiedlich große Austrittsmengen der Behandlungsflüssigkeit.

Der vorliegenden Erfindung liegt daher die Aufgabe zugrunde, eine Düsenanordnung zum Abgeben einer Behandlungsflüssigkeit vorzuschlagen, bei welcher eine weitgehend gleichmäßige Strömungsgeschwindigkeit und Durchflussmenge der Behandlungsflüssigkeit in Längsrichtung der Düsenanordnung erzielt werden kann. Weitere, vorzugsweise zu erfüllende Forderungen sind eine hohe Kompaktheit des Düsenquerschnittes, um möglichst wenig Platz in Anlagen der zuvor genannten Art zu verbrauchen. Außerdem sollen die Anzahl der Bauteile und damit die Fertigungskosten niedrig gehalten werden. Zusätzlich sollen die Strahlen- bzw. Schwallgeometrie und die Strahlrichtung vorzugsweise an allen Austrittsöffnungen immer gleich sein.

Diese Aufgabe wird erfindungsgemäß durch eine Düsenanordnung mit den Merkmalen des Anspruches 1 gelöst. Die Unteransprüche definieren jeweils bevorzugte und vorteilhafte Ausführungsformen der vorliegenden Erfindung.

Die erfindungsgemäße Düsenanordnung weist ein längliches Gehäuse mit mindestens einer Flüssigkeitszufuhröffnung für die Zufuhr einer Behandlungsflüssigkeit und mit mindestens einer in dem Gehäuse ausgebildeten Flüssigkeitsaustrittsöffnung zum Abgeben der Behandlungsflüssigkeit an das zu behandelnde Werkstück auf. In dem Gehäuse ist ein Flüssigkeitskanal zum Zuführen der Behandlungsflüssigkeit von der Flüssigkeitszufuhröffnung zu der mindestens einen Flüssigkeitsaustrittsöffnung ausgebildet. Die mindestens eine Austrittsöffnung kann schlitzförmig oder als eine Reihe hintereinander angeordneter und voneinander gleichmäßig beabstandeter runder Bohrungen ausgeführt sein.

Gemäß einem ersten Ausführungsbeispiel der vorliegenden Erfindung nimmt der Querschnitt des Flüssigkeitskanals ausgehend von der Flüssigkeitszufuhröffnung in Längsrichtung des Gehäuses ab, wobei insbesondere eine kontinuierliche Verringerung des Querschnitts des Flüssigkeitskanals in Längsrichtung und entlang der mindestens einen Flüssigkeitsaustrittsöffnung vorgesehen sein kann. Durch die Anpassung der Durchtrittsquerschnittsfläche des Flüssigkeitskanals an die Entfernung von der Flüssigkeitszufuhröffnung bzw. von dem Flüssigkeitseinlass, wo die größte Flüssigkeitsmenge durchtritt, kann eine Angleichung der Strömungsgeschwindigkeit über die gesamte Länge der Düsenanordnung und somit entlang der mindestens einen Flüssigkeitsaustrittsöffnung erzielt werden.

In einem Gehäuse mit gleichem Querschnitt in Längsrichtung kann ein länglicher Einsatz vorgesehen sein, dessen Querschnitt in Längsrichtung ausgehend von der Flüssigkeitszufuhröffnung zunimmt, so dass sich entsprechend der Querschnitt des Flüssigkeitskanals verringert. Bevorzugt ist der Einsatz gegenüber den Flüssigkeitsaustrittsöffnungen angeordnet, so dass alle Flüssigkeitsaustrittsöffnungen gleich lange Austrittskanäle aufweisen.

Ebenso ist es jedoch auch möglich, dass die Dicke der Gehäusewand an einer oder mehreren Seiten in Längsrichtung des Gehäuses ausgehend von der Flüssigkeitszufuhröffnung zunimmt.

Der Einsatz im Inneren der Düsenanordnung kann z. B. auch aus einzelnen Abschnitten bzw. Segmenten in größerer Anzahl gebildet sein. Diese können Verdrängungskörper oder gelochte Körper sein. So werden z. B. 60 Stück pro Düsenanordnung entsprechend der gewünschten Länge, mit unterschiedlichem Querschnitt, oder bei Scheiben mit unterschiedlichem Innendurchmesser aneinandergereiht. Die einzelnen Abschnitte können verklebt, verschweißt, mit Spannstangen oder mit einer Versteifung zusammengehalten werden. Der Durchtrittsquerschnitt für die Flüssigkeit nimmt dabei von Abschnitt zu Abschnitt vom ersten Segment am Flüssigkeitseintritt zum Ende der Düsenanordnung hin ständig ab. Wenn z. B. ein Abschnitt jeweils eine Austrittsöffnung aufweist, kann der Stauraum im Abschnitt zylinderförmig sein und nicht kegelförmig. Damit entsteht ein stufenförmiger Flüssigkeitskanal bei sehr niedrigen Herstellkosten.

Gemäß einem zweiten Ausführungsbeispiel der vorliegenden Erfindung ist der Flüssigkeitskanal über mehrere in Längsrichtung des Gehäuses voneinander beabstandete Verteileröffnungen verbunden, die eine unterschiedlich Länge aufweisen. Wird die Länge dieser Verteileröffnungen ausgehend von der Flüssigkeitszufuhröffnung in Längsrichtung des Gehäuses zunehmend verändert, kann ebenfalls eine Angleichung der Strömungsgeschwindigkeit der Behandlungsflüssigkeit über die gesamte Länge der Düsenanordnung an den Düsen- bzw. Flüssigkeitsaustrittsöffnungen erzielt werden. Durch die unterschiedlich langen Bohrungen bzw. Verteileröffnungen entstehen unterschiedliche Strömungswiderstände, die zu einer Angleichung der Strömungsgeschwindigkeit führen.

Die zuvor erwähnten Verteileröffnungen können allesamt denselben Durchmesser aufweisen. Ebenso ist jedoch auch denkbar, die Verteileröffnungen mit unterschiedlichen Durchmessern auszugestalten. Maßgebend für die Veränderung der Durchmesser ist eine unterschiedliche Strömungsgeschwindigkeit im Zuführkanal und die damit entstehenden unterschiedlichen Gesamt-Druckverhältnisse.

Gemäß einer weiteren Variante wird daher vorgeschlagen, die Verteileröffnungen mit unterschiedlichen Durchmessern am Flüssigkeitsaustritt und diese mit Ansenkungen mit gleichen Durchmessern zu versehen. Wird der Durchmesser der Ansenkungen gleich gewählt, erfolgt damit eine weitere Vergleichmäßigung von Volumenstrom und Austrittsgeschwindigkeit.

Die obigen Verteileröffnungen können in einem Einsatz der bereits zuvor erwähnten Art in Form entsprechender Bohrungen ausgebildet sein. Der Einsatz kann mit Hilfe einer vorzugsweise u-förmigen Versteifung in dem Gehäuse gehalten sein.

Es wurde beobachtet, dass durch die dynamischen Kräfte der strömenden Flüssigkeit der Strahl an den Flüssigkeitsaustrittsöffnungen nicht im Winkel des Öffnungskanals austritt, sondern schräg in Fließrichtung der Behandlungsflüssigkeit.

Mit zunehmender Länge des Austrittskanals nimmt dieser Effekt ab. Dies führt ebenfalls zu einem ungleichen Behandlungsergebnis am empfindlichen Behandlungsgut.

Besonders vorteilhaft ist es daher, wenn zwischen der mindestens einen Flüssigkeitsaustrittsöffnung und dem Flüssigkeitskanal ein Stauraum, beispielsweise in Form einer entsprechenden Einfräsung oder Ausnehmung des zuvor erwähnten Einsatzes, vorgesehen ist, welche zur weiteren Druckverteilung und zum Abbau der dynamischen Kräfte dient. Die Verteileröffnungen sind in einer bevorzugten Ausführungsform so angeordnet, dass der austretende Flüssigkeitsstrahl gegen die Wand prallt, in der sich die Flüssigkeitsaustrittsöffnungen befinden. Dann wird der Strahl schräg umgelenkt und prallt gegen die Wand des ausgefrästen Einsatzes, um dann nach einer erneuten Umlenkung durch die Flüssigkeitsaustrittsöffnung gegen das Behandlungsgut bzw. Werkstück zu strömen.

Die Flüssigkeitszufuhröffnung bzw. der Einlass für die Behandlungsflüssigkeit kann an einer Längsseite des Gehäuses ausgebildet sein. Selbstverständlich ist jedoch auch denkbar, diese Flüssigkeitszufuhröffnung in einem mittleren Abschnitt des Gehäuses anzuordnen.

Die Flüssigkeitsaustrittsöffnungen sind vorzugsweise in Form von mehreren in Längsrichtung des Gehäuses voneinander beabstandeten Schlitzen ausgebildet, welche allesamt identische Abmessungen oder auch unterschiedliche Abmessungen aufweisen können. Besonders vorteilhaft ist es, wenn die Flüssigkeitsaustrittsöffnungen in Form von mehreren zueinander versetzten Schlitzreihen, die jeweils in Längsrichtung des Gehäuses verlaufen, ausgestaltet sind. Es sind jedoch anstelle der versetzten Schlitzreihen auch versetzte Bohrungsreihen verwendbar. In beiden Fällen erfolgt ein gleichmäßiges Anströmen des Behandlungsgutes.

Wichtig ist auch, dass der Abstand von den Flüssigkeitsaustrittsöffnungen zum Behandlungsgut immer gleich ist. Es sollte somit vermieden werden, dass sich die Düsenanordnung durch den Stau- oder Strahldruck der Behandlungsflüssigkeit verbiegt. Auch bei höheren Temperaturen oder durch den Anfertigungsprozess (z. B. Schweißen) hervorgerufene Verformungen sollten vermieden werden. Die erforderliche Stabilität kann insbesondere dadurch erreicht werden, dass längs verlaufende versteifende Teile aus Metall an oder in der Düsenanordnung vorhanden sind.

Gemäß einem weiteren Ausführungsbeispiel kann die erfindungsgemäße Düsenanordnung wiederum einen sich vorzugsweise beidseitig kontinuierlich verringemden Querschnitt des Flüssigkeitskanals aufweisen, wobei an einer Seite des Gehäuses eine Abdeckung bzw. ein Deckel flüssigkeitsdicht an dem Gehäuse angebracht ist und zusammen mit dem Gehäuse die Flüssigkeitsaustrittsöffnungen definiert. Gemäß diesem Ausführungsbeispiel sind die Flüssigkeitsaustrittsöffnungen insbesondere durch mehrere in Längsrichtung der Düsenanordnung voneinander beabstandet angeordnete Schlitze gebildet, welche quer zur Längsrichtung, d.h. in Breitenrichtung der Düsenanordnung, verlaufen, wobei die Flüssigkeitsaustrittsöffnungen beidseitig der Düsenanordnung angeordnet sind. Jeder Schlitz bzw. Verbindungskanal steht somit einerseits mit dem Flüssigkeitskanal des Gehäuses in Verbindung und mündet andererseits in jeweils zwei Flüssigkeitsaustrittsöffnungen.

Dieses Ausführungsbeispiel eignet sich besonders gut zum vollkommen gleichmäßigen Fluten von Behandlungsbädern mit einer Behandlungsflüssigkeit bzw. einem Behandlungsmedium. Bei bestimmten Verfahren, bei denen die Gefahr besteht, dass aus der Umgebung Stoffe aufgenommen werden, wie beispielsweise Sauerstoff aus der Luft, muss das Fluten möglichst ohne Bildung von Strahlen oder Strudeln, die die Oberfläche der Behandlungsflüssigkeit vergrößern könnten, durchgeführt werden. Diese Aufgabe erfüllt die Düsenanordnung gemäß dem zuvor beschriebenen Ausführungsbeispiel durch eine gleichmäßige, langsame Fließgeschwindigkeit über die gesamte Wirklänge der Düsenanordnung.

Das zuletzt erläuterte Ausführungsbeispiel lässt sich mit den Merkmalen der zuvor beschriebenen Ausführungsbeispiele beliebig kombinieren. Selbstverständlich ist auch eine Realisierung des zuletzt erläuterten Ausführungsbeispiels ohne die zuvor beschriebenen Merkmale betreffend die Ausbildung eines Stauraums oder die Verwendung von Verteileröffnungen etc. möglich.

Die erfindungsgemäße Düsenanordnung eignet sich bevorzugt zum Einsatz als Schwalldüse in naßchemischen Anlagen mit einem horizontalen Durchlauf der Leiterplatten. Selbstverständlich ist jedoch die vorliegende Erfindung nicht auf diesen bevorzugten Anwendungsbereich beschränkt. Sie kann überall dort zum Einsatz kommen, wo ein Werkstück über eine Düsenanordnung mit Behandlungsflüssigkeit, beispielsweise auch zur Reinigung oder chemischen Behandlung etc. des Werkstücks, angeströmt werden soll oder ein möglichst gleichmäßiges Fluten eines Behandlungsbads mit einer derartigen Behandlungsflüssigkeit möglich sein soll. In allgemeinster Form kann daher die Erfindung überall dort eingesetzt werden, wo eine möglichst gleichmäßige Abgabe einer Behandlungsflüssigkeit gewünscht ist.

Die vorliegende Erfindung wird nachfolgend näher unter Bezugnahme auf die beigefügten Zeichnungen anhand eines bevorzugten Ausführungsbeispiels erläutert.
Figur 1 zeigt eine Seitenansicht einer erfindungsgemäßen Düsenanordnung in einer einfachen Form im Teilquerschnitt entlang einer in Figur 4 dargestellten Schnittlinie B-B',
Figur 2 zeigt eine Seitenansicht einer erfindungsgemäßen Düsenanordnung als Alternative zu Figur 1 im Teilquerschnitt entlang der in Figur 4 dargestellten Schnittlinie B-B',
Figur 3 zeigt eine Seitenansicht einer erfindungsgemäßen Düsenanordnung in einer bevorzugten Ausführungsform mit zusätzlichem Stauraum zur Druckverteilung im Teilquerschnitt entlang der in Figur 4 dargestellten Schnittlinie B-B',
Figur 4 zeigt eine Draufsicht auf die in Figur 3 dargestellte Düsenanordnung im Teilquerschnitt entlang einer in Figur 3 dargestellten Schnittlinie A-A',
Figur 5 zeigt eine Seitenansicht eines in Figur 3 und Figur 4 dargestellten Einsatzes sowie einer Versteifung zum Halten dieses Einsatzes in der Düsenanordnung,
Figur 6 zeigt eine Seitenansicht einer erfindungsgemäßen Düsenanordnung in einer alternativen Ausführung zu Figur 3 bzw. Figur 4 im Teilquerschnitt entlang der in Figur 4 dargestellten Schnittlinie B-B',
Figur 7 zeigt eine Querschnittsansicht der Düsenanordnung von Figur 3 entlang einer in Figur 3 dargestellten Schnittlinie C-C',
Figur 8 zeigt eine Seitenansicht einer erfindungsgemäßen Düsenanordnung gemäß einem weiteren Ausführungsbeispiel in Form eines Teilquerschnitts,
Figur 9 zeigt eine Draufsicht auf die in Figur 8 dargestellte Düsenanordnung im Teilquerschnitt, und
Figur 10 zeigt eine Querschnittsansicht der Düsenanordnung von Figur 8 und Figur 9 entlang einer in Figur 8 dargestellten Schnittlinie C-C.

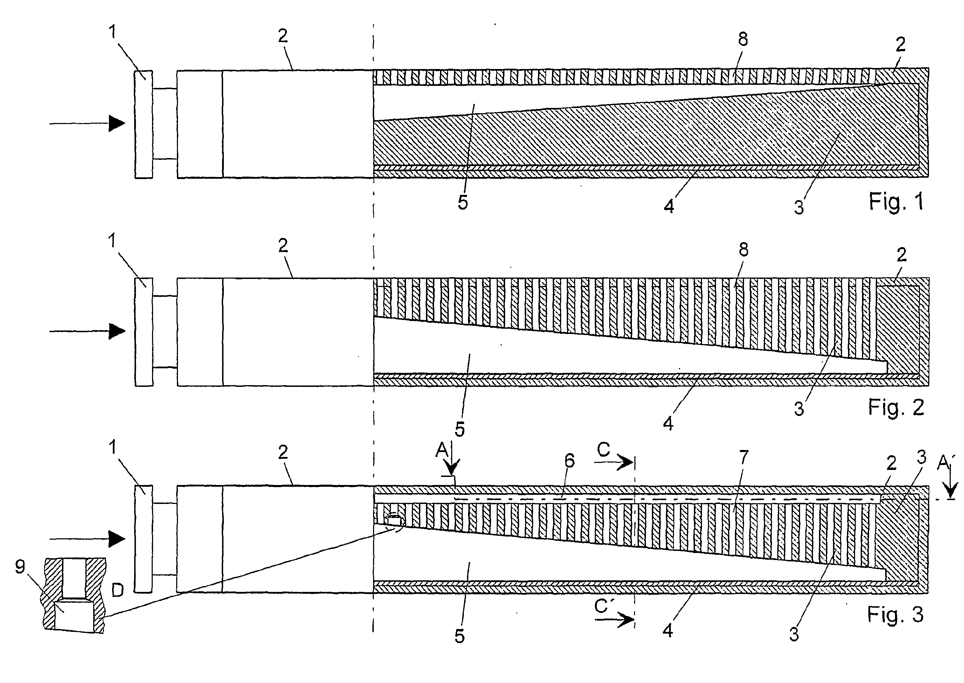

Die in Figur 1 dargestellte Düsenanordnung, welche sich insbesondere als Schwalldüse für Galvanisierungsanlagen mit einem horizontalen Durchlauf von Leiterplatten eignet, umfasst ein im Wesentlichen quaderförmiges Gehäuse 2. An einer Stirnfläche des Gehäuses 2 ist ein mit einer Flüssigkeitszufuhröffnung des Gehäuses gekoppelter Anschlussstutzen 1 für die Zufuhr einer Behandlungsflüssigkeit vorgesehen. An einer dem zu behandelnden Werkstück bzw. dem Behandlungsgut gegenüberliegend anzuordnenden Seitenfläche des Gehäuses 2 sind zueinander versetzte Schlitz- oder Bohrungsreihen angeordnet, die Austrittsöffnungen 8 für die Behandlungsflüssigkeit bilden. Bei den dargestellten Ausführungsbeispielen weisen alle schlitzartigen Austrittsöffnungen oder Bohrungen 8 die gleichen Abmessungen und demzufolge die gleiche Länge und Breite bzw. Durchmesser auf. Es können jedoch auch unterschiedliche Abmessungen gewählt werden, um ein vorbestimmtes Sprüh bzw. Schwallbild zu erzeugen.

Im Inneren des Gehäuses 2 ist ein keilförmiger Einsatz 3, welcher vorzugsweise aus Kunststoff gefertigt ist, und eine u-förmige Versteifung 4 zur Stabilisierung dieses Einsatzes 3 angeordnet, die aus einem, gegen die verwendeten Chemikalien beständigem Metall wie z. B. Edelstahl, Titan, Niob oder dergleichen, besteht.

Wie nachfolgend näher beschrieben ist, dient der Einsatz 3 zum Vergleichmäßigen der Strömungsgeschwindigkeit im Flüssigkeitskanal und damit zur gleichmäßigen Verteilung der Behandlungsflüssigkeit über die gesamte Länge der Düsenanordnung.

Wie insbesondere aus Figur 1 ersichtlich, ist der Einsatz 3 in Längsrichtung konisch verlaufend, so dass er an seinem dem Anschlussstutzen 1 benachbart angeordneten Ende die geringste Dicke und an seinem entgegengesetzten Ende die größte Dicke aufweist. Zwischen dem Einsatz 3 und der Versteifung 4 besteht ein als Flüssigkeitskanal 5 für die Behandlungsflüssigkeit dienender Hohlraum. An dem mit dem Anschlussstutzen 1 gekoppelten Ende ist der Durchflussquerschnitt dieses Flüssigkeitskanals 5 demzufolge am Größten und nimmt kontinuierlich zum entgegengesetzten Ende hin, wo der Durchflussquerschnitt am geringsten ist, ab.

Die Düsenanordnung weist an der dem Behandlungsgut gegenüberstehenden Fläche entlang ihrer Länge die vorzugsweise gleichmäßig voneinander beabstandete Austrittsöffnungen 8 in Form von Durchgangsbohrungen auf, welche bei dem dargestellten Ausführungsbeispiel allesamt denselben Durchmesser besitzen. Anstelle der dargestellten Bohrungen können auch schlitzförmige Austrittsöffnungen verwendet werden.

Wie wiederum Figur 1 entnommen werden kann, ist die Länge dieser Austrittsöffnungen 8 über die gesamte Länge der Düsenanordnung gleich.
Die Behandlungsflüssigkeit wird der Düsenanordnung in Pfeilrichtung über den Anschlussstutzen 1 in den Flüssigkeitskanal 5 zugeführt und in Längsrichtung zu den Austrittsöffnungen 8 weitergeleitet.

Da durch den keilförmigen Einsatz 3 die Strömungsgeschwindigkeit an allen Stellen des Flüssigkeitskanals 5 gleich hoch ist und alle Austrittsöffnungen 8 gleiche Abmessungen aufweisen, entsteht ein sehr gleichmäßiges Spritzbild.

Gemäß Figur 2 ist der keilförmige Einsatz im oberen Teil der Düsenanordnung angeordnet. Die Austrittsöffnungen 8 sind im Gehäuse 2 und im Einsatz 3 deckungsgleich vorhanden. Dadurch entstehen unterschiedlich lange Austrittskanäle bei gleichem Durchmesser der Austrittsöffnungen. Die unterschiedlich langen Austrittskanäle können zu einer weiteren Angleichung des Spritzbildes verwendet werden. In den längeren Bohrungen in größerer Entfernung vom Flüssigkeitseinlauf entsteht ein sich zum Ende hin vergrößernder Strömungswiderstand, der für eine weitere Angleichung der Strömungsverhältnisse sorgt.

Gemäß Figur 3 ist in einem Einsatz 3 eine Einfräsung oder Ausnehmung sowie in Längsrichtung des Einsatzes 3 voneinander beabstandete Verteileröffnungen 7 ausgebildet. Durch die Einfräsung oder Ausnehmung am Einsatz 3 entsteht zwischen den Verteileröffnungen 7 des Einsatzes 3 und den in dem Gehäuse 2 ausgebildeten schlitzartigen Austrittsöffnungen 8 (in dieser Figur nicht dargestellt) ein Stauraum 6 für die Behandlungsflüssigkeit, welcher zur weiteren Druckverteilung dient. Der aus jeder Verteileröffnung 7 austretende Flüssigkeitsstrahl wird zunächst gegen die obere Gehäusewand gestrahlt, von dort schräg nach unten gegen die Einsatzwand 3 gelenkt, um nach einem erneuten Richtungswechsel durch die schlitzartige Austrittsöffnung 8 zu dem Behandlungsgut 10 hin auszutreten. Diese Umlenkung baut die dynamische Kraft der bewegten Flüssigkeit gezielt ab.

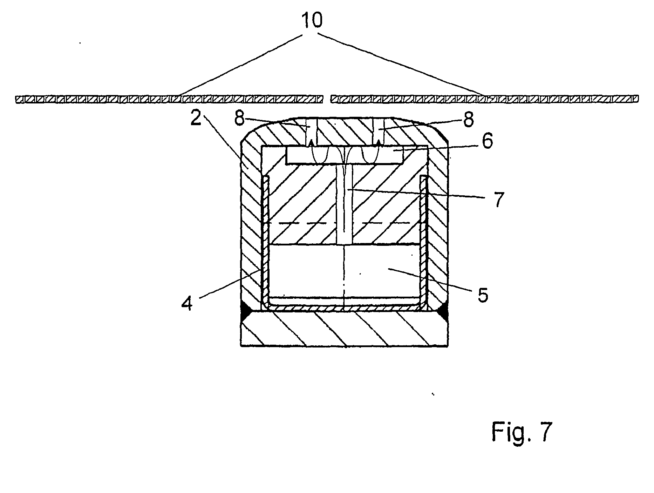

Figur 7 zeigt als Schnitt C-C', in Figur 3 dargestellt, weitere Einzelheiten der Düsenanordnung.

Die Verteileröffnungen 7 sind durch den keilförmigen Einsatz 3 unterschiedlich lang. Ist dieser Längenunterschied störend, können die Bohrungen zur Anpassung der Strömungsverhältnisse mit unterschiedlich langen Ansenkungen 9 gemäß Ausschnitt D (in Figur 3 dargestellt) versehen werden.

Eine Kombination des sich fortlaufend verkleinernden Flüssigkeitskanals 5 von der Zufuhröffnung zum entgegengesetzten Ende der Düsenanordnung hin in Verbindung mit dem Stauraum 6 und der Mehrfachumlenkung des Flüssigkeitsstromes vor dem Austritt aus den Austrittsöffnungen 8 (z. B einer Schlitzreihe) sorgt dafür, dass die Menge der austretenden Flüssigkeit pro Schlitz und die Austrittsgeschwindigkeit gleich groß sind.

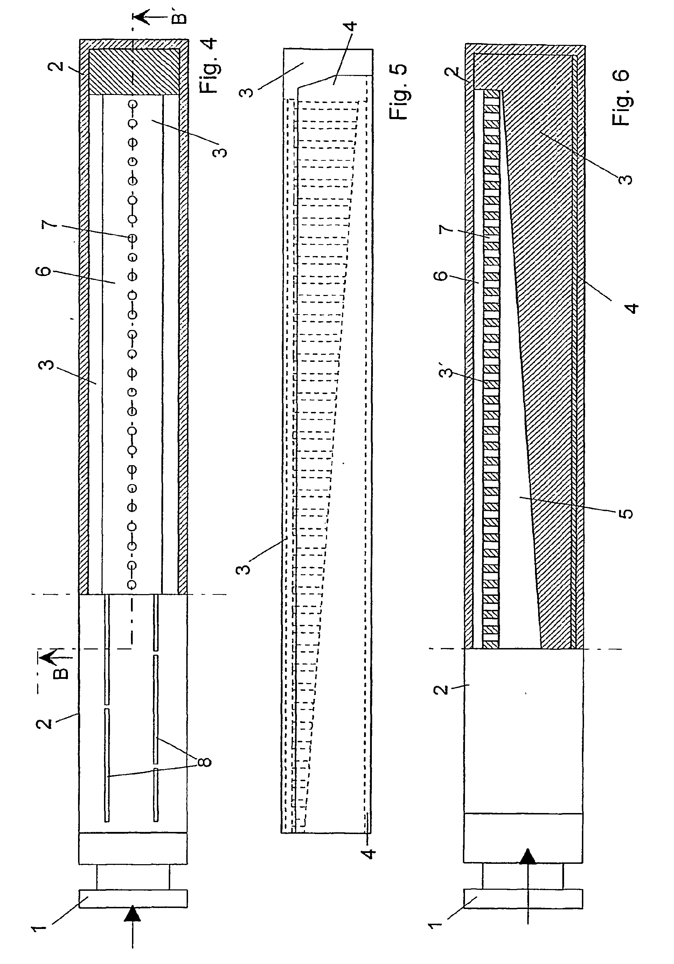

Wie aus Figur 5 ersichtlich ist, verläuft die Versteifung 4 im Wesentlichen über die gesamte Länge des Einsatzes 3. Am äußeren Ende der Versteifung ist der Einsatz 3 um die Wandstärke der Versteifung verdickt. Dies dient zum dichten Abschluss des Flüssigkeitskanals 5 im Inneren des Gehäuses 2 der Düsenanordnung (vgl. auch Figur 3). Auch entlang seiner Oberseite ist der Einsatz 3 in gleicher Stärke verdickt, so dass er sicher auf der u-förmigen Versteifung 4 aufsitzt, wie dies Figur 7 entnommen werden kann. Es ist jedoch auch möglich, die u-förmige Versteifung außen am Gehäuse 2 anzubringen. Zu diesem Zweck kann die Verdickung am Einsatz 3 entfallen. Die Versteifung kann zusätzlich mittels z. B. Schrauben am Gehäuse befestigt sein. Die Schrauben sollten jedoch nicht in den Flüssigkeitskanal 5 hineinragen.

Bei dem in den Figuren 3-7 dargestellten Ausführungsbeispielen wird eine gleichmäßige Strömungsgeschwindigkeit der Behandlungsflüssigkeit an den Austrittsöffnungen 8 im Prinzip durch zwei Maßnahmen realisiert. Zum einen nimmt der Durchtrittsquerschnitt für die Behandlungsflüssigkeit im Inneren der Düsenanordnung, das heißt im Flüssigkeitskanal 5, von dem Anschlussstutzen 1 zum Ende der Düsenanordnung hin durch den schräg verlaufenden Einsatz 3 kontinuierlich ab. Zum anderen leiten die Verteileröffnungen 7 den Flüssigkeitsstrahl nicht direkt zum Behandlungsgut. Er wird stattdessen zweimal umgelenkt, um dann erst durch die Flüssigkeitsaustrittsöffnungen 8, in diesen Beispielen sind dies Schlitzreihen, auszutreten.

Der Strömungswiderstand in den Verteileröffnungen 7 nimmt aufgrund deren kontinuierlich zunehmenden Länge ständig zu. Damit dies keinen Einfluss auf die Flüssigkeitsverteilung hat, wird die Schräge des Einsatzes 3, in den Figuren 2, 3, und 5 dargestellt, vorzugsweise etwas flacher gewählt, so dass am Ende der Düsenanordnung noch ein Spalt verbleibt. Im Beispiel der Fig. 3 beträgt die Spalthöhe am Ende etwa 4 mm.

Eine Kombination der beiden Maßnahmen (schräger Einsatz und Flüssigkeitsumlenkung im zusätzliche Stauraum) führt zu den besten Ergebnissen, da die Querschnittsverkleinerung des Flüssigkeitskanals 5 alleine unter Umständen nur einen zu geringen Druckausgleich hervorrufen kann und die Strahlen schräg austreten. Da mit dieser Kombination die Austrittsöffnungen 8 vorzugsweise alle gleiche Breiten bzw. Durchmesser aufweisen, strömt an allen Austrittsöffnungen auch das gleiche Flüssigkeitsvolumen pro Zeiteinheit aus.

Figur 6 zeigt ein weiteres Beispiel einer Düsenanordnung mit einem Stauraum 6. Hier sind zwei Einsätze 3 und 3' vorhanden. Der Einsatz 3 ist, wie schon beschrieben, keilförmig und im unteren Teil der Düsenanordnung eingebaut. Der Einsatz 3' im oberen Teil der Düsenanordnung hat über die gesamte Länge den gleichen Querschnitt. Im Einsatz 3' befinden sich Verteilerbohrungen 7. Sie haben alle die gleiche Länge. Dementsprechend verläuft der keilförmige Flüssigkeitskanal am Ende spitzer aus als in den Figuren 2, 3, und 5 dargestellt.

Dennoch kann bereits gegebenenfalls durch Realisierung lediglich einer der beiden zuvor beschriebenen Maßnahmen eine für den jeweiligen Anwendungsfall ausreichend gleichmäßige Strömungsgeschwindigkeit der Behandlungsflüssigkeit an den Austrittsöffnungen 8 erzielt werden.

Selbstverständlich sind eine Reihe von Modifikationen der in den Figuren dargestellten Ausführungsbeispiele denkbar, ohne von dem Grundgedanken der vorliegenden Erfindung abzuweichen. So könnte beispielsweise der Anschlussstutzen 1 in die Mitte des Gehäuses 2 der Düsenanordnung verlegt werden, so dass die Zufuhr der Behandlungsflüssigkeit mittig erfolgt. Bei dieser Abwandlung würde dann der Durchtrittsquerschnitt des Flüssigkeitskanals 5 im Inneren des Gehäuses 2 ausgehend von dem mittigen Anschlussstutzen 1 zu den beiden Enden des Gehäuses 2 hin, das heißt beidseitig, abnehmen und sich die Dicke des Einsatzes 3 entsprechend ausgehend von dem mittigen Anschlussstutzen 1 zu den beiden Enden hin verbreitern, so dass auch die Länge der Verteilerbohrungen 7 in dem Einsatz 3 beidseitig zunimmt.

Des Weiteren wird bei den dargestellten Ausführungsbeispielen der sich kontinuierlich reduzierende Durchtrittsquerschnitt des Flüssigkeitskanals 5 alleine durch die zunehmende Breite des Einsatzes 3 realisiert. Selbstverständlich ist auch denkbar, dass mehrere Seitenflächen des Flüssigkeitskanals 5 in Längsrichtung des Gehäuses 2 zunehmend verbreitert werden. Darüber hinaus kann gegebenenfalls auf den Stauraum 6 zur weiteren Druckverteilung verzichtet werden.

Zur Verbesserung der Gleichmäßigkeit der Strömungsgeschwindigkeit können die schlitzartigen Austrittsöffnungen 8 auch mit einer unterschiedlichen Breite versehen werden, wobei die Breite insbesondere in Längsrichtung des Gehäuses 2 ausgehend von dem Einlassstutzen 1 abnehmen kann. Dies führt in der Regel zu unterschiedlichen Volumenströmen, die ungleiche Ergebnisse am Behandlungsgut erbringen können.

Abweichend von den dargestellten Ausführungsbeispielen können die Verteileröffnungen 7 auch mit unterschiedlichen Durchmessern ausgestaltet sein, wobei zur Realisierung eines kontinuierlich zunehmenden Strömungswiderstands insbesondere eine kontinuierliche Reduzierung der Durchmesser der Verteileröffnungen 7 denkbar ist, da zum Ende der Düsenanordnung hin der Gesamtdruck am höchsten ist.

An der an den Flüssigkeitskanal 5 angrenzenden Seite der Verteileröffnungen 7 können diese mit Ansenkungen 9 mit einem größeren Durchmesser versehen werden (vgl. Figur 3). Zur Realisierung eines in Längsrichtung des Gehäuses 2 kontinuierlich zunehmenden Strömungswiderstands können diese Ansenkungen mit einer unterschiedlichen Tiefe, insbesondere mit einer in Längsrichtung des Gehäuses 2 kontinuierlich zunehmenden Tiefe, versehen werden. Ebenso ist denkbar, dass der Einsatz 3 und das Gehäuse 2 einteilig ausgestaltet sind. Schließlich sollte auch darauf hingewiesen werden, dass bei dem dargestellten Ausführungsbeispiel zwar eine Vielzahl von in Längsrichtung des Gehäuses 2 beabstandeten Austrittsöffnungen 8 vorgesehen sind, welche insbesondere gleichmäßig beabstandet und in zwei zueinander versetzten Schlitzreihen angeordnet sind, wobei jedoch im Prinzip eine ordnungsgemäße und zufrieden stellende Funktionsfähigkeit der Düsenanordnung auch bereits bei lediglich einer insbesondere länglichen Austrittsöffnung 8, beispielsweise bei lediglich einer sich in Längsrichtung des Gehäuses 2 schlitzartig erstreckenden Austrittsöffnung 8, gewährleistet ist.

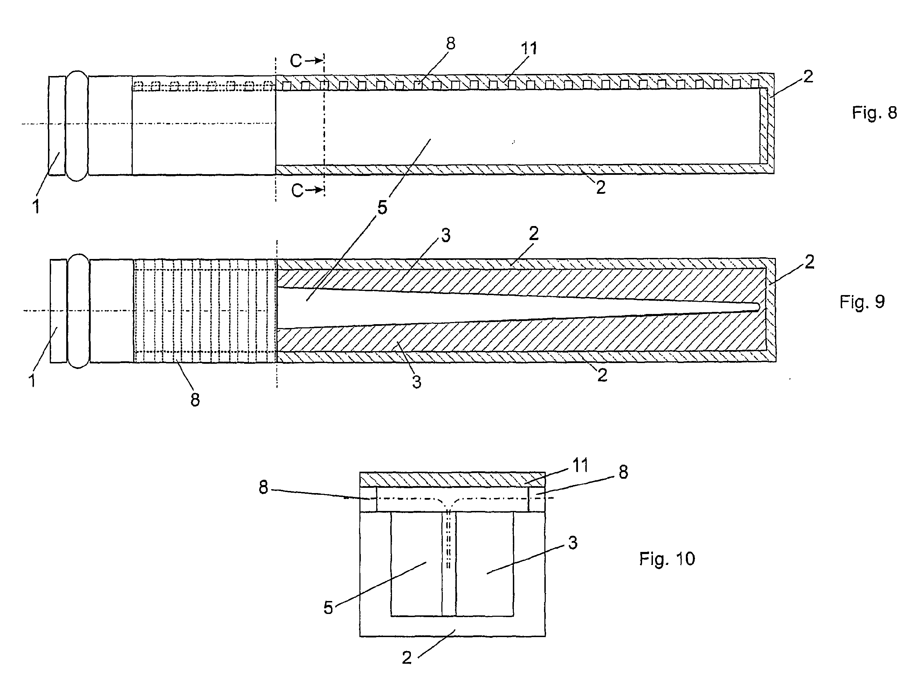

In Figur 8-10 ist eine weitere Düsenanordnung gemäß einem Ausführungsbeispiel der vorliegenden Erfindung dargestellt, wobei Figur 8 eine Seitenansicht der Düsenanordnung im Teilquerschnitt, Figur 9 eine Draufsicht der Düsenanordnung im Teilquerschnitt und Figur 10 eine Querschnittsansicht der Düsenanordnung entlang einer in Figur 8 gezeigten Schnittlinie C-C darstellt.

Bei der in Figur 8-10 gezeigten Düsenanordnung handelt es sich um ein Ausführungsbeispiel, welches besonders gut zum gleichmäßigen Fluten von Behandlungsbädern mit einer Behandlungsflüssigkeit geeignet ist. Bei bestimmten Verfahren, bei denen die Gefahr besteht, dass aus der Umgebung Stoffe, wie beispielsweise Sauerstoff aus der Luft, aufgenommen werden, muss das Fluten möglichst ohne Bildung von Strahlen oder Strudeln, die die Oberfläche der Behandlungsflüssigkeit vergrößern könnten, durchgeführt werden. Dies erfüllt die in Figur 8-10 dargestellte Düsenanordnung durch eine gleichmäßige, langsame Fließgeschwindigkeit über die gesamte Wirklänge der Düsenanordnung.

Die in Figur 8-10 dargestellte Düsenanordnung umfasst wie die zuvor beschriebenen Ausführungsformen einen Anschlussstutzen 1 und ein längliches, im Wesentlichen quaderförmiges Gehäuse 2, in dem eine Einsatz 3 eingebaut ist, welcher einen Flüssigkeitskanal 5 mit in Längsrichtung der Düsenanordnung bzw. des Gehäuses 2 kontinuierlich abnehmendem Querschnitt definiert. Aus Figur 9 ist diesbezüglich ersichtlich, dass insbesondere der Einsatz 3 beidseitig den Querschnitt des Flüssigkeitskanals 5 verringert, wobei der Querschnitt des Flüssigkeitskanals 5 vom Anschlussstutzen 1 bis zum Ende der Düsenanordnung kontinuierlich und gleichmäßig verkleinert wird, so dass im Flüssigkeitskanal 5 selbst stets annähernd die gleiche Fließgeschwindigkeit der Behandlungsflüssigkeit vorhanden ist.

An einer Seite des Gehäuses 2 ist eine Abdeckung bzw. ein Deckel 11 flüssigkeitsdicht durch eine geeignete Fügetechnik, wie beispielsweise durch Schweißen oder Kleben, an dem Gehäuse 2 angebracht. Wie aus Figur 8 und Figur 9 ersichtlich ist, weist die Abdeckung 11 an ihrer Unterseite eine Vielzahl von quer zur Längsrichtung der Düsenanordnung verlaufende Schlitze oder Verbindungskanäle auf, welche insbesondere gleichmäßig über die gesamte Wirkungslänge der Düsenanordnung voneinander beabstandet verteilt sind. Diese Schlitze der Abdeckung 11 bilden zusammen mit dem Gehäuse 2 Flüssigkeitsaustrittsöffnungen 8 für die Behandlungsflüssigkeit.

Wie Figur 10 entnommen werden kann, kann bei dieser Ausführungsform die über den Anschlussstutzen 1 der Düsenanordnung zugeführte Behandlungsflüssigkeit von dem Flüssigkeitskanal 5 über die in der Abdeckung 11 ausgebildeten Schlitze an den beidseitig der Düsenanordnung bzw. des Gehäuses 2 vorgesehenen Flüssigkeitsaustrittsöffnungen 8 austreten.

Selbstverständlich kann die in Figur 8-10 dargestellte Düsenanordnung auch mit den Merkmalen der zuvor anhand von Figur 1-7 beschriebenen Düsenanordnungen kombiniert werden.

Die Beschreibung der erfindungsgemäßen Düsenanordnung bezieht sich in allen Ausführungsbeispielen auf das Fördern der Behandlungsflüssigkeit von der Düsenanordnung zum Behandlungsgut. Die Düsenanordnung funktioniert in gleicher Weise auch für das Absaugen der Behandlungsflüssigkeit vom Behandlungsgut in die Düsenanordnung hinein. Wenn während der Behandlung Abbauprodukte entstehen oder Feststoffe abgetragen werden, ist diese Form der Elektrolytförderung besonders vorteilhaft. Mit dem Einsaugen der Behandlungsflüssigkeit in die Düsenanordnung werden die Abbauprodukte oder Feststoffe mitgerissen und gelangen so auf dem schnellsten Wege zu einer Regenerationseinheit oder z. B. einem Filter der die Feststoffe entfernt. Eine Beeinträchtigung des Behandlungsergebnisses durch diese Stoffe ist damit nahezu ausgeschlossen.

### Bezugszeichenliste

- 1.: Anschlussstutzen
- 2.: Gehäuse
- 3.: Einsatz
- 4.: Versteifung
- 5.: Flüssigkeitskanal
- 6.: Stauraum
- 7.: Verteileröffnungen (Verteilerbohrungen)
- 8.: Flüssigkeitsaustrittsöffnungen
- 9.: Ansenkungen
- 10.: Behandlungsgut
- 11.: Abdeckung

## Patentansprüche

1. Düsenanordnung zum Abgeben einer Behandlungsflüssigkeit,
mit einem länglichen Gehäuse (2) mit mindestens einer Flüssigkeitszufuhröffnung für die Zufuhr der Behandlungsflüssigkeit und mindestens einer in dem Gehäuse (2) ausgebildeten Flüssigkeitsaustrittsöffnung (8) zum Abgeben der Behandlungsflüssigkeit,
wobei in dem Gehäuse (2) ein Flüssigkeitskanal (5) zum Zuführen der Behandlungsflüssigkeit von der Flüssigkeitszufuhröffnung zu der mindestens einen Flüssigkeitsaustrittsöffnung (8) ausgebildet ist, und
wobei sich der Querschnitt des Flüssigkeitskanals (5) ausgehend von der Flüssigkeitszufuhröffnung in Längsrichtung des Gehäuses (2) verringert,
**dadurch gekennzeichnet,**
**dass** das Gehäuse (2) aus Kunststoff gefertigt und an oder in der Düsenanordnung mindestens ein in Längsrichtung der Düsenanordnung verlaufendes versteifendes Teil (4) aus Metall vorhanden ist, und
**dass** in der Düsenanordnung ein länglicher Einsatz (3, 3'), in dem mehrere in Längsrichtung voneinander beabstandet angeordnete Verteileröffnungen (7) ausgebildet sind, angeordnet ist, so dass der durch den Einsatz (3, 3') definierte Flüssigkeitskanal (5) über die Verteileröffnungen (7) mit der mindestens einen Flüssigkeitsaustrittsöffnung (8) in Verbindung steht, um die Behandlungsflüssigkeit von dem Flüssigkeitskanal (5) über die Verteileröffnungen (7) der mindestens einen Flüssigkeitsaustrittsöffnung (8) zuzuführen

2. Düsenanordnung nach Anspruch 1,
**dadurch gekennzeichnet,**
**dass** sich der Querschnitt des Flüssigkeitskanals (5) ausgehend von der Flüssigkeitszufuhröffnung in Längsrichtung des Gehäuses (2) kontinuierlich verringert.

3. Düsenanordnung nach Anspruch 1 oder 2,
**dadurch gekennzeichnet,**
**dass** die Verteileröffnungen (7) des Einsatzes (3, 3') deckungsgleich mit den Flüssigkeitsaustrittsöffnungen (8) im Gehäuse (2) angeordnet sind.

4. Düsenanordnung nach einem der vorhergehenden Ansprüche,
**dadurch gekennzeichnet,**
**dass** sich der Querschnitt des Flüssigkeitskanals (5) ausgehend von der Flüssigkeitszufuhröffnung in Längsrichtung des Gehäuses (2) von mehreren Seiten verringert.

5. Düsenanordnung nach Anspruch einem der vorhergehenden Ansprüche,
**dadurch gekennzeichnet,**
**dass** alle Verteileröffnungen (7) denselben Durchmesser aufweisen.

6. Düsenanordnung nach einem der vorhergehenden Ansprüche,
**dadurch gekennzeichnet,**
**dass** die Länge der Verteileröffnungen (7) ausgehend von der Flüssigkeitszufuhröffnung in Längsrichtung des Gehäuses (2) zunimmt.

7. Düsenanordnung nach einem der Ansprüche 1-5,
**dadurch gekennzeichnet,**
**dass** die Länge der Verteileröffnungen (7) der Flüssigkeitszufuhröffnung in Längsrichtung des Gehäuses (2) gleich ist.

8. Düsenanordnung nach einem der Ansprüche 1-4,
**dadurch gekennzeichnet,**
**dass** die Verteileröffnungen (7) einen unterschiedlichen Durchmesser aufweisen.

9. Düsenanordnung nach Anspruch 8,
**dadurch gekennzeichnet,**
**dass** sich der Durchmesser der Verteileröffnungen (7) ausgehend von der Flüssigkeitszufuhröffnung in Längsrichtung des Gehäuses (2) verringert.

10. Düsenanordnung nach einem der vorhergehenden Ansprüche,
**dadurch gekennzeichnet,**
**dass** die Verteileröffnungen (7) an ihrer dem Flüssigkeitskanal (5) zugewandten Seite mit Ansenkungen (9) versehen sind.

11. Düsenanordnung nach Anspruch 10,
**dadurch gekennzeichnet,**
**dass** die Ansenkungen (9) der Verteileröffnungen (7) eine unterschiedliche Tiefe aufweisen.

12. Düsenanordnung nach Anspruch 11,
**dadurch gekennzeichnet,**
**dass** die Tiefe der Ansenkungen (9) der Verteileröffnungen (7) ausgehend von der Flüssigkeitszufuhröffnung in Längsrichtung des Gehäuses (2) zunimmt.

13. Düsenanordnung nach einem der vorhergehenden Ansprüche,
**dadurch gekennzeichnet,**
**dass** das Gehäuse (2) im Wesentlichen quaderförmig und das versteifende Teil (4) im Wesentlichen u-förmig ausgebildet ist.

14. Düsenanordnung nach einem der vorhergehenden Ansprüche,
**dadurch gekennzeichnet,**
**dass** zwischen der mindestens einen Flüssigkeitsaustrittsöffnung (8) und dem Flüssigkeitskanal (5) und unmittelbar vor der mindestens einen Flüssigkeitsaustrittsöffnung (8) ein Stauraum (6) zur Druckverteilung ausgebildet ist.

15. Düsenanordnung nach Anspruch 14,
**dadurch gekennzeichnet,**
**dass** der Stauraum (6) in Form einer in dem länglichen Einsatz (3, 3') an der der mindestens einen Flüssigkeitsaustrittsöffnung (8) zugewandten Seite der Verteileröffnungen (7) vorgesehenen Ausnehmung ausgebildet ist.

16. Düsenanordnung nach Anspruch 15,
**dadurch gekennzeichnet,**
**dass** alle Verteileröffnungen (7) räumlich zu der mindestens einen Flüssigkeitsaustrittsöffnung (8) so versetzt angeordnet sind, dass die Behandlungsflüssigkeit über den Stauraum erst nach mindestens zweimaligem Fließrichtungswechsel aus den Flüssigkeitsaustrittsöffnungen (8) ausströmt.

17. Düsenanordnung nach einem der vorhergehenden Ansprüche,
**dadurch gekennzeichnet,**
**dass** die mindestens eine Flüssigkeitszufuhröffnung an einem Längsende des Gehäuses (2) vorgesehen ist.

18. Düsenanordnung nach einem der Ansprüche 1-16,
**dadurch gekennzeichnet,**
**dass** die mindestens eine Flüssigkeitszufuhröffnung an einem mittleren Abschnitt des Gehäuses (2) vorgesehen ist.

19. Düsenanordnung nach einem der vorhergehenden Ansprüche,
**dadurch gekennzeichnet,**
**dass** das Gehäuse (2) mehrere in Längsrichtung des Gehäuses (2) voneinander beabstandete Flüssigkeitsaustrittsöffnungen (8) aufweist.

20. Düsenanordnung nach Anspruch 19,
**dadurch gekennzeichnet,**
**dass** die Flüssigkeitsaustrittsöffnungen (8) schlitzförmig oder rund sind.

21. Düsenanordnung nach Anspruch 19 oder 20,
**dadurch gekennzeichnet,**
**dass** die Flüssigkeitsaustrittsöffnungen (8) dieselben Abmessungen aufweisen.

22. Düsenanordnung nach Anspruch 19 oder 20,
**dadurch gekennzeichnet,**
**dass** die Flüssigkeitsaustrittsöffnungen (8) eine sich ausgehend von der Flüssigkeitszufuhröffnung über die Länge des Gehäuses (2) verringernde Breite oder einen sich über die Länge des Gehäuses (2) verringernden Durchmesser besitzen.

23. Düsenanordnung nach einem der Ansprüche 19-22,
**dadurch gekennzeichnet,**
**dass** die schlitzförmigen Flüssigkeitsaustrittsöffnungen (8) in mehreren zueinander versetzten Reihen in dem Gehäuse (2) ausgebildet sind.

24. Düsenanordnung nach einem der vorhergehenden Ansprüche,
**dadurch gekennzeichnet,**
**dass** in dem Gehäuse (2) mehrere in Längsrichtung des Gehäuses (2) voneinander beabstandete und sich in Breitenrichtung des Gehäuses (2) erstreckende Verbindungskanäle ausgebildet sind, welche einerseits mit dem Flüssigkeitskanal (5) in dem Gehäuse (2) und andererseits mit jeweils mindestens einer Flüssigkeitsaustrittsöffnung (8) in Verbindung stehen.

25. Düsenanordnung nach Anspruch 24,
**dadurch gekennzeichnet,**
**dass** die Verbindungskanäle in einer Abdeckung (11), welche an dem Gehäuse (2) angebracht ist, ausgebildet sind.

26. Düsenanordnung nach Anspruch 25,
**dadurch gekennzeichnet,**
**dass** die Abdeckung (11) flüssigkeitsdicht an dem Gehäuse (2) angebracht ist.

27. Düsenanordnung nach einem der Ansprüche 24-26,
**dadurch gekennzeichnet,**
**dass** die Verbindungskanäle gleichmäßig voneinander in Längsrichtung des Gehäuses (2) beabstandet angeordnet sind.

28. Düsenanordnung nach einem der Ansprüche 24-27,
**dadurch gekennzeichnet,**
**dass** die Verbindungskanäle im Wesentlichen über die gesamte Länge des Gehäuses (2) verteilt sind.

29. Düsenanordnung nach einem der Ansprüche 24-28,
**dadurch gekennzeichnet,**
**dass** jeder Verbindungskanal im Wesentlichen geradlinig quer zur Längsrichtung des Gehäuses (2) verläuft.

30. Düsenanordnung nach einem der Ansprüche 24-29,
**dadurch gekennzeichnet,**
**dass** jeder Verbindungskanal beidseitig des Gehäuses (2) in jeweils eine der Flüssigkeitsaustrittsöffnungen (8) mündet.

31. Düsenanordnung nach einem der vorhergehenden Ansprüche,
**dadurch gekennzeichnet,**
**dass** ein weiterer länglicher Einsatz (3), welcher konisch in seiner Längsrichtung ausgestaltet ist, in dem Gehäuse (2) angeordnet ist und mit dem länglichen Einsatz (3'), welcher die Verteileröffnungen (7) aufweist, den Flüssigkeitskanal (5) definiert.

## Claims

1. Nozzle arrangement for releasing a treatment fluid,
with a longitudinal housing (2) with at least one fluid feed opening for feeding the treatment fluid and at least one fluid delivery opening (8) formed in the housing (2) for releasing the treatment fluid,
whereby in the housing (2) a fluid channel (5) is formed for feeding the treatment fluid from the fluid feed opening to the at least one fluid delivery opening (8), and
whereby the section of the fluid channel (5) reduces from the fluid feed opening in the longitudinal direction of the housing (2),
**characterized in that**
the housing (2) is made from plastic, and at or in the nozzle arrangement at least one stiffening member (4) made from metal and extending in the longitudinal direction of the nozzle arrangement is provided, and
in the nozzle arrangement a longitudinal insert (3, 3'), in which a plurality of distribution openings (7) spaced from one another in the longitudinal direction is formed, is arranged so that the fluid channel (5) defined by the insert (3, 3') is in communication with the at least one fluid delivery opening (8) via the distribution openings (7), in order to feed the treatment fluid from the fluid channel (5) via the distribution openings (7) to the at least one fluid delivery opening (8).

2. Nozzle arrangement according to claim 1,
**characterized in that**
the section of the fluid channel (5) reduces continuously from the fluid feed opening in the longitudinal direction of the housing (2).

3. Nozzle arrangement according to claim 1 or 2,
**characterized in that**
the distribution openings (7) of the insert (3, 3') are positioned congruent to the fluid delivery openings (8) in the housing (2).

4. Nozzle arrangement according to any one of the preceding claims,
**characterized in that**
the section of the fluid channel (5) reduces from the fluid feed opening in the longitudinal direction of the housing (2) from a number of sides.

5. Nozzle arrangement according to any one of the preceding claims,
**characterized in that**
all the distribution openings (7) have the same diameter.

6. Nozzle arrangement according to any one of the preceding claims,
**characterized in that**
the length of the distribution openings (7) increases from the fluid feed opening in the longitudinal direction of the housing (2).

7. Nozzle arrangement according to any one of claims 1-5,
**characterized in that**
the length of the distribution openings (7) of the fluid feed opening in the longitudinal direction of the housing (2) is the same.

8. Nozzle arrangement according to any one of claims 1-4,
**characterized in that**
the distribution openings (7) have a differing diameter.

9. Nozzle arrangement according to claim 8,
**characterized in that**
the diameter of the distribution openings (7) reduces from the fluid feed opening in the longitudinal direction of the housing (2).

10. Nozzle arrangement according to any one of the preceding claims,
**characterized in that**
the distribution openings (7) are provided with countersinkings (9) on their side turned towards the fluid channel (5).

11. Nozzle arrangement according to claim 10,
**characterized in that**
the countersinkings (9) of the distribution openings (7) have a different depth.

12. Nozzle arrangement according to claim 11,
**characterized in that**
the depth of the countersinkings (9) of the distribution openings (7) increases from the fluid feed opening in the longitudinal direction of the housing (2).

13. Nozzle arrangement according to any one of the preceding claims,
**characterized in that**
the housing (2) is essentially parallelepiped in shape and the stiffening member (4) is essentially U-shaped.

14. Nozzle arrangement according to any one of the preceding claims,
**characterized in that**
between the at least one fluid delivery opening (8) and the fluid channel (5) and immediately before the at least one fluid delivery opening (8) a storage chamber (6) is formed for pressure distribution.

15. Nozzle arrangement according to claim 14,
**characterized in that**
the storage chamber (6) is in the form of a recess provided in the longitudinal insert (3, 3') on the side of the distribution openings (7) turned towards the at least one fluid delivery opening (8).

16. Nozzle arrangement according to claim 15,
**characterized in that**
all distribution openings (7) are arranged spatially at an offset to the at least one fluid delivery opening (8) in such a way that the treatment fluid flows out of the fluid delivery openings (8) via the storage chamber only after at least two changes in direction.

17. Nozzle arrangement according to any one of the preceding claims,
**characterized in that**
the at least one fluid feed opening is provided at a longitudinal end of the housing (2).

18. Nozzle arrangement according to any one of claims 1-16,
**characterized in that**
the at least one fluid feed opening is provided at a middle section of the housing (2).

19. Nozzle arrangement according to any one of the preceding claims,
**characterized in that**
the housing (2) has a plurality of fluid delivery openings (8) spaced from one another in the longitudinal direction of the housing (2).

20. Nozzle arrangement according to claim 19,
**characterized in that**
the fluid delivery openings (8) are slotted or round.

21. Nozzle arrangement according to claim 19 or 20,
**characterized in that**
the fluid delivery openings (8) have the same dimensions.

22. Nozzle arrangement according to claim 19 or 20,
**characterized in that**
the fluid delivery openings (8) have a reducing width from the fluid feed opening over the length of the housing (2) or a reducing diameter over the length of the housing (2).

23. Nozzle arrangement according to any one of claims 19-22,
**characterized in that**
the slotted fluid delivery openings (8) are formed in a plurality of rows offset from one another in the housing (2).

24. Nozzle arrangement according to any one of the preceding claims,
**characterized in that**
in the housing (2) a plurality of connecting channels spaced from one another and extending widthways in the housing (2) are formed in the longitudinal direction of the housing (2), which communicate at one end with the fluid channel (5) in the housing (2) and at the other with the at least one fluid delivery opening (8).

25. Nozzle arrangement according to claim 24,
**characterized in that**
the connecting channels are formed in a cover (11) which is positioned on the housing (2).

26. Nozzle arrangement according to claim 25,
**characterized in that**
the cover (11) is positioned with a fluid-tight seal at the housing (2).

27. Nozzle arrangement according to any one of claims 24-26,
**characterized in that**
the connecting channels are arranged evenly spaced in the longitudinal direction of the housing (2).

28. Nozzle arrangement according to any one of claims 24-27,
**characterized in that**
the connecting channels are distributed essentially over the entire length of the housing (2).

29. Nozzle arrangement according to any one of claims 24-28,
**characterized in that**
each connecting channel extends essentially in a straight line transversely to the longitudinal direction of the housing (2).

30. Nozzle arrangement according to any one of claims 24-29,
**characterized in that**
each connecting channel opens out into one of the fluid delivery openings (8) at either side of the housing (2).

31. Nozzle arrangement according to any one of the preceding claims,
**characterized in that**
a further longitudinal insert (3), which is conical in its longitudinal direction, is arranged in the housing (2) and defines together with the longitudinal insert (3') having the distribution openings (7) the fluid channel (5).

## Revendications

1. Ensemble à buses pour délivrer un liquide de traitement,
comportant un boîtier (2), allongé, qui présente au moins une ouverture d'arrivée de liquide, pour l'amenée du liquide de traitement, et au moins une ouverture de sortie de liquide (8) formée dans le boîtier (2), pour la délivrance du liquide de traitement,
un canal à liquide (5) étant aménagé dans le boîtier (2), pour amener le liquide de traitement de l'ouverture d'amenée de liquide à la au moins une ouverture de sortie de liquide (8), et
la section transversale du canal à liquide (5) diminuant dans la direction longitudinale du boîtier (2), en partant de l'ouverture d'arrivée de liquide,
**caractérisé**
**en ce que** le boîtier (2) est réalisé en matière plastique et, sur ou dans l'ensemble à buses, est présent au moins un élément de rigidification (4) en métal, s'étendant dans la direction longitudinale de l'ensemble à buses, et
**en ce que** dans l'ensemble à buses, est disposé un insert allongé (3, 3'), dans lequel sont formés plusieurs orifices répartiteurs (7) disposés à intervalle l'un de l'autre en direction longitudinale, de telle sorte que le canal à liquide (5) défini par l'insert (3, 3'), soit placé en liaison avec la au moins une ouverture de sortie de liquide (8), au travers des orifices répartiteurs (7), pour que le liquide de traitement soit amené à la au moins une ouverture de sortie de liquide (8) au travers des orifices répartiteurs (7), depuis le canal à liquide (5).

2. Ensemble à buses selon la revendication 1,
**caractérisé**
**en ce que** la section transversale du canal à liquide (5) diminue d'une façon continue dans la direction longitudinale du boîtier (2), en partant de l'ouverture d'arrivée de liquide.

3. Ensemble à buses selon la revendication 1 ou 2,
**caractérisé**
**en ce que** les orifices répartiteurs (7) de l'insert (3, 3') sont disposés de façon à être en coïncidence avec les ouvertures de sortie de liquide (8) dans le boîtier (2).

4. Ensemble à buses selon l'une des revendications précédentes,
**caractérisé**
**en ce que** la section transversale du canal à liquide (5) diminue de plusieurs côtés dans la direction longitudinale du boîtier (2), en partant de l'ouverture d'arrivée de liquide.

5. Ensemble à buses selon l'une des revendications précédentes,
**caractérisé,**
**en ce que** tous les orifices répartiteurs (7) présentent le même diamètre.

6. Ensemble à buses selon l'une des revendications précédentes,
**caractérisé**
**en ce que** la longueur des orifices répartiteurs (7) augmente dans la direction longitudinale du boîtier (2), en partant de l'ouverture d'arrivée de liquide.

7. Ensemble à buses selon l'une des revendications 1 à 5,
**caractérisé**
**en ce que** la longueur des orifices répartiteurs (7) de l'ouverture d'arrivée de liquide est identique dans la direction longitudinale du boîtier (2).

8. Ensemble à buses selon l'une des revendications 1 à 4,
**caractérisé**
**en ce que** les orifices répartiteurs (7) présentent un diamètre différent.

9. Ensemble à buses selon la revendication 8,
**caractérisé**
**en ce que** le diamètre des orifices répartiteurs (7) diminue dans la direction longitudinale du boîtier (2), en partant de l'ouverture d'arrivée de liquide.

10. Ensemble à buses selon l'une des revendications précédentes,
**caractérisé**
**en ce que** les orifices répartiteurs (7) sont, de leur côté tourné vers le canal à liquide (5), pourvus de fraisages (9).

11. Ensemble à buses selon la revendication 10,
**caractérisé**
**en ce que** les fraisages (9) des orifices répartiteurs (7) présentent une profondeur différente.

12. Ensemble à buses selon la revendication 11,
**caractérisé**
**en ce que** la profondeur des fraisages (9) des orifices répartiteurs (7) augmente dans la direction longitudinale du boîtier (2), en partant de l'ouverture d'arrivée de liquide.

13. Ensemble à buses selon l'une des revendications précédentes,
**caractérisé**
**en ce que** le boîtier (2) est doté d'une configuration sensiblement parallélépipédique et l'élément de rigidification (4) d'une configuration sensiblement en forme de u.

14. Ensemble à buses selon l'une des revendications précédentes,
**caractérisé**
**en ce qu'**entre la au moins une ouverture de sortie de liquide (8) et le canal à liquide (5) et immédiatement en amont de la au moins une ouverture de sortie de liquide (8), est aménagé un espace d'accumulation (6) pour la répartition de pression.

15. Ensemble à buses selon la revendication 14,
**caractérisé**
**en ce que** l'espace d'accumulation (6) est réalisé sous forme d'un évidement prévu dans l'insert allongé (3, 3'), du côté des orifices répartiteurs (7) tourné vers la au moins une ouverture de sortie de liquide (8).

16. Ensemble à buses selon la revendication 15,
**caractérisé**
**en ce que** tous les orifices répartiteurs (7) sont disposés sous un décalage dans l'espace qui, vis-à-vis de la au moins une ouverture de sortie de liquide (8), est tel que le liquide de traitement ne sorte des ouvertures de sortie de liquide (8), en passant par l'espace d'accumulation, qu'après avoir changé au moins deux fois de sens d'écoulement.

17. Ensemble à buses selon l'une des revendications précédentes,
**caractérisé**
**en ce que** la au moins une ouverture d'arrivée de liquide est prévue à une extrémité, dans la direction longitudinale, du boîtier (2).

18. Ensemble à buses selon l'une des revendications 1 à 16,
**caractérisé**
**en ce que** la au moins une ouverture d'arrivée de liquide est prévue au niveau d'un tronçon médian du boîtier (2).

19. Ensemble à buses selon l'une des revendications précédentes,
**caractérisé**
**en ce que** le boîtier (2) présente plusieurs ouvertures de sortie de liquide (8) placées à intervalle l'une de l'autre dans la direction longitudinale du boîtier (2).

20. Ensemble à buses selon la revendication 19,
**caractérisé**
**en ce que** les ouvertures de sortie de liquide (8) sont en forme de fente ou rondes.

21. Ensemble à buses selon la revendication 19 ou 20,
**caractérisé**
**en ce que** les ouvertures de sortie de liquide (8) présentent les mêmes dimensions.

22. Ensemble à buses selon la revendication 19 ou 20,
**caractérisé**
**en ce que** les ouvertures de sortie de liquide (8) possèdent une largeur diminuant sur la longueur du boîtier (2), en partant de l'ouverture d'arrivée de liquide, ou un diamètre diminuant sur la longueur du boîtier (2).

23. Ensemble à buses selon l'une des revendications 19 à 22,
**caractérisé**
**en ce que** les ouvertures de sortie de liquide (8), en forme de fente, sont formées en plusieurs rangées décalées l'une de l'autre, dans le boîtier (2).

24. Ensemble à buses selon l'une des revendications précédentes,
**caractérisé**
**en ce que** dans le boîtier (2), sont aménagés plusieurs canaux de jonction espacés l'un de l'autre dans la direction longitudinale du boîtier (2) et s'étendant dans le sens de la largeur du boîtier (2), lesquels canaux de jonction sont reliés, d'une part, au canal à liquide (5) ménagé dans le boîtier (2) et, d'autre part, à au moins une ouverture de sortie de liquide (8) respectivement.

25. Ensemble à buses selon la revendication 24,
**caractérisé**
**en ce que** les canaux de jonction sont aménagés dans un couvercle (11), qui est adapté sur le boîtier (2).

26. Ensemble à buses selon la revendication 25,
**caractérisé**
**en ce que** le couvercle (11) est adapté sur le boîtier (2) avec établissement d'une étanchéité aux liquides.

27. Ensemble à buses selon l'une des revendications 24 à 26,
**caractérisé**
**en ce que** les canaux de jonction sont disposés suivant un espacement mutuel uniforme dans la direction longitudinale du boîtier (2).

28. Ensemble à buses selon l'une des revendications 24 à 27,
**caractérisé**
**en ce que** les canaux de jonction sont répartis sensiblement sur la longueur entière du boîtier (2).

29. Ensemble à buses selon l'une des revendications 24 à 28,
**caractérisé**
**en ce que** chaque canal de jonction s'étend transversalement à la direction longitudinale du boîtier (2), sous une forme sensiblement rectiligne.

30. Ensemble à buses selon l'une des revendications 24 à 29,
**caractérisé**
**en ce que**, des deux côtés du boîtier (2), chaque canal de jonction débouche respectivement dans l'une des ouvertures de sortie de liquide (8).

31. Ensemble à buses selon l'une des revendications précédentes,
**caractérisé**
**en ce qu'**un insert allongé supplémentaire (3), qui est doté d'une forme conique dans sa direction longitudinale, est disposé dans le boîtier (2) et définit le canal à liquide (5) avec l'insert allongé (3') qui comporte les orifices répartiteurs (7).
